# EUROPÄISCHE PATENTANMELDUNG

(11) **EP 3 401 962 A1**
(43) Veröffentlichungstag der Anmeldung: **14.11.2018**
(21) Anmeldenummer: 17170885.2
(22) Anmeldetag: 12.05.2017
(51) Int. Cl.: H01L 31/05

(54) **ABWECHSELND UMLAUFEND BESCHICHTETE SOLARZELLVERBINDER**

(71) Anmelder: Heraeus Deutschland GmbH & Co. KG, 63450 Hanau (DE)
(72) Erfinder: Koenig, Markus, 64807 Dieburg (DE)
(74) Vertreter: Heraeus IP

(57) **Zusammenfassung**

Die vorliegende Erfindung betrifft einen Verbinder zum Verbinden einer Solarzellenelektrode mit einem weiteren Element sowie ein Verfahren zu dessen Herstellung und ein Photovoltaikbauteil, in welchem der Verbinder verwendet wird. Der Verbinder weist eine metallische Leiterstruktur auf, die dadurch gekennzeichnet ist, dass die Leiterstruktur entlang der Hauptrichtung abwechselnd umlaufend mit den Materialien A und B beschichtet ist, wobei A ein Lotmaterial und B ein dielektrisches Material ist.

## Beschreibung

Die vorliegende Erfindung betrifft einen Verbinder zum Verbinden einer Solarzellenelektrode mit einem weiteren Element sowie ein Verfahren zu dessen Herstellung und ein Photovoltaikbauteil, in welchem der Verbinder verwendet wird.

Eine Solarzelle besteht typischer Weise mindestens aus einer Halbleiterschicht, die von mindestens zwei Elektroden unterschiedlicher Polarität kontaktiert wird. Die Halbleiterschicht ist in den meisten Fällen eine dotierte Siliziumschicht, die in Form eines monokristallinen oder multikristallinen Silizium-Wafers vorliegt. Üblicher Weise befinden sich die unterschiedlich gepolten Elektroden auf entgegengesetzten Seiten der Halbleiterschicht. Wenn Licht auf die Solarzelletrifft, kommt es zu einer Ladungstrennung in der Halbleiterschicht und die Ladungen können als Strom an den Elektroden abgegriffen werden. Um höhere Spannungen abgreifen zu können, werden mehrere Solarzellen in Reihe geschaltete und dadurch zu Photovoltaikmodulen verbunden. Um mehrere Solarzellen zu Photovoltaikmodulen zu verschalten, werden die Solarzellenelektroden benachbarter Solarzellen mit einem Verbinder verbunden.

Der Verbinder ist typischer Weise ein Metallband, insbesondere ein Kupferband. Die Kontaktierung der Solarzellenelektroden erfolgt meistens durch Löten. Dazu wird ein Kupferband mit einer dünnen Schicht einer Lotlegierung beschichtet und dieses beschichtete Band wird anschließend mit den Elektroden von zwei Solarzellen verlötet. In dem am häufigsten verwendeten Szenario verbindet ein Verbinder die Frontseitenelektrode einer ersten Solarzelle mit der Rückseitenelektrode einer weiteren Solarzelle, wobei Front- und Rückseitenelektrode unterschiedliche Polaritäten aufweisen. Um eine lange Lebensdauer der Photovoltaikmodule zu gewährleisten, ist es zwingend erforderlich, dass der Kontakt zwischen Verbinder und Solarzellenelektrode eine hohe mechanische Festigkeit und eine hohe elektrische Leitfähigkeit aufweist. Der Kontakt, bzw. die Kontaktfläche zwischen der Solarzellenelektrode und dem Verbinder ist sowohl mechanischer als auch chemischer Beanspruchung ausgesetzt. Dies kann zu einer Alterung der Kontakte über die Lebensdauer der Photovoltaikmodule führen. Zum einen führen unterschiedliche thermische Ausdehnungskoeffizienten der verwendeten Materialien unter thermischer Wechsellast (z.B. Tag/Nacht-Zyklen) zu mechanischen Spannungen. Solche mechanischen Spannungen können zu messbaren Verbiegungen der Solarzelle und einer mechanischen Beanspruchung in der Grenzfläche der Lötverbindung führen. Im Extremfall können die Spannungen dazu führen, dass der Kontakt bricht. Zum anderen sind der Verbinder und insbesondere die Kontaktfläche, wegen der dort fließenden Elektronen, der Korrosion ausgesetzt. Insbesondere erfolgt die Korrosion durch Oxidation unter Einwirkung von Feuchtigkeit und Luftsauerstoff.

Um eine dauerhaft haltbare Verbindung zu erzielen, ist es daher wünschenswert, die mechanischen Spannungen innerhalb des Photovoltaikmoduls zu verringern. Dies kann beispielsweise durch eine punktuelle anstatt einer flächigen Kontaktierung der Solarzellenelektrode mit dem Verbinder erreicht werden. Solche punktuellen Kontaktierungen sind im Stand der Technik bekannt. Meistens sind die vereinzelten Kontaktpunkte auf dem Verbinder zusätzlich auf federnden bzw. flexiblen Elementen, wie zum Beispiel Aussparungen, angeordnet, um auftretende Spannungen sowohl lateral als auch vertikal kompensieren zu können.

US20110126878 offenbart Verbinder für Rückkontakt-Solarzellen. Bei Rückkontaktzellen sind Anode und Kathode auf der Rückseite der Solarzelle angeordnet. Die hier verwendeten Verbinder sind einseitig beschichtete Kupferbänder und weisen auf einer Seite des Kupferbands vereinzelte Bereiche auf, die entweder mit der Anode oder der Kathode in Kontakt stehen. Die vereinzelten Kontaktbereiche sind durch Bereiche einer isolierenden Schicht auf dem Verbinder voneinander getrennt. Solche Verbinder, wie sie in der US20110126878 beschriebensind, sind nicht zum Verbinden von Frontseiten-Rückseiten-Solarzellen geeignet, da sie nur auf einer Seite bereichsweise mit kontaktierenden Lotbereichen beschichtet sind.

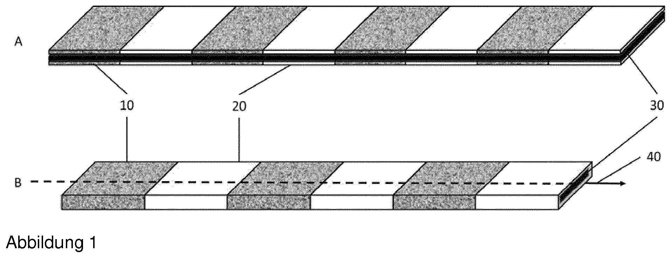

Selektiv mit Lot beschichtete Verbinder aus Kupfer zum Verbinden der Frontseite einer Solarzelle mit der Rückseite einer weiteren Solarzelle sind aus WO2008046648 bekannt. Die darin beschriebenen Kontaktbereiche sind punktuell und zueinander versetzt auf den beiden Hauptflächen eines Metallbands angeordnet. Zwischen den einzelnen Kontaktbereichen sind Bereiche einer isolierenden Schicht angeordnet. Da die Kontaktbereiche und die isolierenden Bereiche hier nur punktuell und nicht umlaufend auf dem Verbinder aufgetragen sind (dargestellt in Abbildung 1A wo die offene Seite des Metallbands zu erkennen ist), können sie den Kupferverbinder nicht ausreichend vor Korrosion schützen. Ein weiterer Nachteil von punktuell auf einer Seite mit Kontaktbereichen eines Lotmaterials beschichteten Verbindern ist, dass eine genaue Positionierung des Verbinders erforderlich ist, beim Verbinden von Solarzellen zu Photovoltaikmodulen.

Die Aufgabe der vorliegenden Erfindung war es, einen Verbinder bereitzustellen, der die Alterungsbeständigkeit von Photovoltaikmodulen, insbesondere gegenüber thermischer Wechsellast und Umwelteinflüssen wie Feuchtigkeit und Luftsauerstoff, verbessert. Eine weitere Aufgabe war es, ein einfaches Verfahren zur Herstellung des erfindungsgemäßen Verbinders bereitzustellen.

Bevorzugt löst, die Erfindung zusätzlich die Aufgabe Lotmaterial zu sparen, gegenüber einem vollflächig mit Lot beschichteten Verbinder.

Die Aufgaben werden gelöst durch einen Verbinder zum Verbinden einer ersten Solarzellenelektrode mit einem weiteren Element, wobei der Verbinder eine metallische Leiterstruktur aufweist, dadurch gekennzeichnet, dass die Leiterstruktur entlang der Hauptrichtung abwechselnd umlaufend mit den Materialien A und B beschichtet ist, wobei A ein Lotmaterial und B ein dielektrisches Material ist.

Ein möglicher Vorteil des erfindungsgemäßen Verbinders ergibt sich aus der bevorzugt symmetrisch um die Leiterstruktur angeordneten umlaufenden Beschichtung. Dadurch hat der Verbinder im Herstellungsprozess keine Vorzugsausrichtung, da er eine Solarzellenelektrode mit beiden Seiten kontaktieren kann. Somit kann die Handhabung während des Herstellungsverfahrens vereinfacht werden.

Ein weiterer Vorteil von umlaufend beschichteten Verbindern ist, dass die Beschichtung die Leiterstruktur besser gegen Korrosion schützen kann. Eine beispielhafte Ausführung des erfindungsgemäßen Verbinders ist in Abbildung 1B dargestellt. In Abbildung 1B ist eine Leiterstruktur 30 dargestellt, die abwechselnd und umlaufend mit einem Lotmaterial 10 und einem dielektrischen Material 20 beschichtet ist.

Die vorliegende Erfindung betrifft einen Verbinder zum Verbinden einer ersten Solarzellenelektrode mit einem weiteren Element. Bevorzugt ist das weitere Element eine Solarzellenelektrode einer weiteren Solarzelle oder eine Anschlussleitung für ein Photovoltaikmodul. Vorzugsweise wird der erfindungsgemäße Verbinder verwendet, um mehrere Solarzellen in Reihe zu schalten.

Eine Solarzelle enthält mindestens: eine Halbleiterschicht, eine positive Solarzellenelektrode (Kathode) und eine negative Solarzellenelektrode (Anode). Im Rahmen der Erfindung ist eine Solarzellenelektrode immer auf einer Solarzelle angeordnet. Positive und negative Elektrode sind bevorzugt auf unterschiedlichen Seiten der Halbleiterschicht angeordnet. Die Elektroden unterschiedlicher Polarität können auch auf derselben Seite der Halbleiterschicht angeordnet sein (sogen. Back contact cells). Bevorzugt verbindet der Verbinder die positive Solarzellenelektrode einer ersten Solarzelle mit der negativen Solarzellenelektrode einer weiteren Solarzelle. Der Verbinder muss eine besonders hohe Leitfähigkeit aufweisen und eine mechanisch und elektrisch stabile Verbindung zwischen den Elektroden der Solarzellen herstellen können. Dies wird durch den erfindungsgemäßen Verbinder erreicht.

Der Verbinder umfasst eine metallische Leiterstruktur. Die Leiterstruktur enthält bevorzugt Kupfer oder besteht aus Kupfer. Wenn die Leiterstruktur aus Kupfer besteht bedeutet dies, dass die Leiterstruktur mindestens 99,90 Gewichts-% Kupfer aufweist. In einer bevorzugten Ausführung kann die Leiterstruktur aus Kupfer hergestellt sein, dass den Industriestandards Cu-ETP oder Cu-OFC genügt.

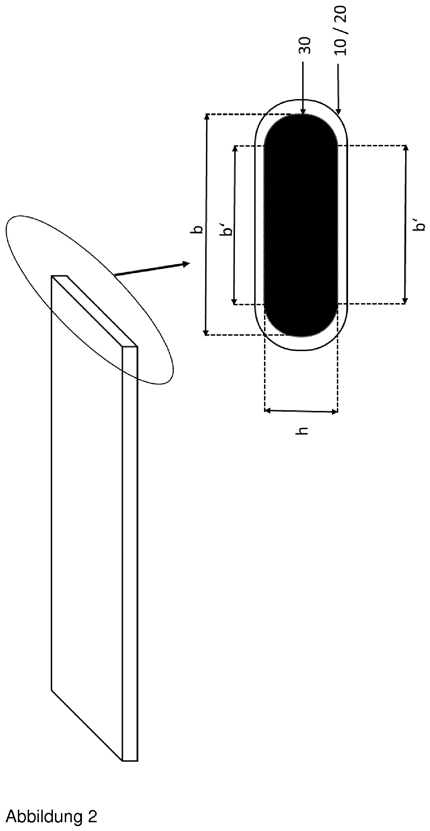

Die metallische Leiterstruktur kann ein Metallband oder ein Metalldraht sein. Bevorzugt ist die metallische Leiterstruktur ein Band, insbesondere ein Kupferband. Das Band weist bevorzugt einen rechteckigen oder annähernd rechteckigen Querschnitt auf. Bei einem annähernd rechteckigen Querschnitt kann die breite Seite b am Band oben und unten zueinander parallel stehende Flächen b' aufweisen, während die kurze Seite h abgerundet sein kann (siehe Abbildung 2). Ein Querschnitt des Bandes mit parallelen breiten Seiten b' und abgerundeten Seiten h kann beispielsweiße erhalten werden, indem ein Runddraht flach gewalzt wird. Die Breite b des Bands ist bevorzugt mindestens doppelt so lang wie die Höhe h. Die bevorzugte Seitenlänge der kürzeren Seite h liegt im Bereich von 0,1 mm - 0,4 mm, insbesondere im Bereich von 0,16 mm - 0,3 mm. Die Seitenlänge der langen Seiten b liegt bevorzugt im Bereich von 0,6 - 2,0 mm, insbesondere im Bereich von 0,9 mm - 1,5 mm. Die metallische Leiterstruktur weist eine Hauptachse (40) entlang ihrer längsten Ausdehnungsrichtung auf (veranschaulicht in Abbildung 1B). In einer bevorzugten Ausführung verläuft die Hauptachse entlang der Stromrichtung.

Die Länge der Leiterstruktur entlang der Hauptachse ist nicht weiter beschränkt. Bevorzugt weist die Leiterstruktur eine Länge auf, die ausreicht um zwei nebeneinander positionierte Solarzellen über ihre Elektroden miteinander zu verbinden. Dabei kann die Länge der Leiterstruktur beispielsweise doppelt so lang sein, wie die Länge einer zu verbindenden Solarzelle. Insbesondere liegt die Länge der Leiterstruktur im Bereich von 100 - 600 mm und ganz besonders bevorzugt im Bereich von 200 - 400 m.

Die metallische Leiterstruktur weist bevorzugt mindestens eine der folgenden mechanischen Eigenschaften auf:
- Eine Zugspannung Rm im Bereich von 100 - 300 MPa, bevorzugt maximal 280 MPa.
- Eine Streckgrenze Rp0,2 im Bereich von 40 - 120 MP, bevorzugt maximal 80 MPa
- Eine Bruchdehnung A100 im Bereich von 10 - 40%, bevorzugt minimal 25%

Optional kann die Leiterstruktur auch mehrere oder alle der genannten mechanischen Eigenschaften erfüllen.

Die Leiterstruktur ist entlang der Hauptachse abwechselnd und umlaufend mit den Materialien A und B beschichtet. Bevorzugt stehen also die abwechselnd umlaufend mit Materialien A und B beschichteten Bereiche nicht direkt im Kontakt miteinander. Bevorzugt beschichten die Materialien A und B die Leiterstruktur entlang der Hauptrichtung so vollständig, dass keine Lücken zwischen den jeweils mit Material A und Material B beschichteten Bereichen vorliegen, d.h. die Oberfläche der Leiterstruktur ist vollständig bedeckt und nicht direkt zugänglich. Durch die umlaufende Beschichtung sind alle Seiten der Leiterstruktur entweder mit Material A oder B bedeckt. In einer besonders bevorzugten Ausführung kann Material A das Material B teilweise überlappen. Die abwechselnd umlaufenden Bereiche können auch als Ringe oder Streifen um die Leiterstruktur verstanden werden. Durch die umlaufende Beschichtung ist die Leiterstruktur besonders gut gegen Umwelteinflüsse geschützt die zu Korrosion der Leiterstruktur führen können. Dadurch kann ein besonders alterungsresistenter elektrischer Kontakt zwischen dem Verbinder und einer Solarzellenelektrode erreicht werden.

Material A ist ein Lotmaterial. Bevorzugt enthält das Lotmaterial eine Lotlegierung oder besteht aus einer Lotlegierung. Eine Lotlegierung ist ein metallisches Gemisch aus Elementen, von denen mindestens eines ein Metall ist. Bevorzugt sind alle Elemente der Legierung Metalle. Bevorzugt weist die Lotlegierung einen Schmelzpunkt aufweist, der mindestens 100°C unter der Schmelztemperatur der Leiterstruktur liegt. Bevorzugte Lotlegierungen enthalten Element, die ausgewählt sind aus der Gruppe bestehend aus, Sn, Pb, Ag, Bi, Cu, Zn, Au, Sb, Cd, Co und Al. Bevorzugt besteht die Lotlegierung aus mindestens zwei dieser Elemente. Besonders bevorzugte Legierungen sind ausgewählt aus der Gruppe enthaltend SnPb, SnPbAg, SnPbBi, SnAg, SnAgBi, SnAgCu, SnBi und SnCu. Die Lotlegierung kann ausgewählt sein aus bleihaltigen Lotlegierungen und bleifreien Lotlegierungen. Besonders bevorzugte bleihaltige Legierungen sind ausgewählt aus der Gruppe bestehend aus Sn₆₂Pb₃₆Ag₂, Sn₆₃Pb₃₇ und Sn₆₀Pb₄₀. Besonders bevorzugte bleifreie Legierungen sind ausgewählt aus der Gruppe bestehend aus Sn_{96,5}Ag_{3,5}, Sn_{96,5}Ag₃Cu_{0,5}, Sn₆₀Bi₄₀, Sn₅₀Bi₄₈Ag₂, Sn₄₂Bi₅₇Ag₁, Sn₄₃Bi₅₇, Sn₅₀Bi₅₀ und Sn99,3Cu_{0,7}. Das Lotmaterial kann bis auf unvermeidliche Verunreinigungen aus der Lotlegierung bestehen. Bevorzugt beträgt die Gesamtmenge der Bestandteile, die nicht der Lotlegierung zugerechnet werden können, nicht mehr als 0,1 Gew.-%, insbesondere nicht mehr als 0,01 Gew.-%.

Alternativ kann das Lotmaterial eine Lotlegierung enthalten, wobei das Lotmaterial zusätzlich andere Bestandteile enthält. Das Lotmaterial kann beispielsweise Flussmittel, Lösungsmittel sowie andere Additiven aufweisen. Das Flussmittel ist bevorzugt ausgewählt aus organischen Säuren, wie zum Beispiel Kolophonium oder Adipinsäure, anorganischen Salzen, wie z.B. Ammoniumchlorid, anorganische Säuren, wie z.B. Phosphorsäure. Bevorzugt sind die Flussmittel frei von Halogeniden. Bevorzugt ist das Lösungsmittel ein organisches oder wässriges Lösungsmittel. Die Additive sind bevorzugt Aktivatoren. Bekannte Aktivatoren sind z.B. halogenidhaltige Verbindungen. Bevorzugt liegt der Anteil an den genannten Rückständen aus Flussmittel und Aktivatoren im Lotmaterial im Bereich von 1 Gew.-% oder weniger, insbesondere 0,1 Gew.-% oder weniger. Die anderen Bestandteile im Lotmaterial können in einer bevorzugten Ausführung Rückstände einer Lotpaste sein, wie sie im Verfahren zur Herstellung des Verbinders hierin beschrieben ist.

Die Schichtdicke der abwechselnd umlaufenden Bereiche von Material A liegt bevorzugt im Bereich von 5 µm - 40 µm und besonders bevorzugt im Bereich von 10 µm - 20 µm. Die umlaufenden Bereiche können verschiedene Ausrichtungen relativ zur Hauptachse aufweisen. Die umlaufenden Bereiche können im rechten Winkel zur Hauptachse der Leiterstruktur ausgerichtet sein oder einen von 90° abweichenden Winkel zur Hauptachse aufweisen. Die Projektion der umlaufenden Bereiche auf die Leiterstruktur kann in einer bevorzugten Ausführung eine gerade oder eine gebogene Linie darstellen, solange sich dabei ein geschlossener, umlaufender Bereich um die Leiterstruktur ergibt.

Material B ist ein dielektrisches Material. Bevorzugt ist Material B ein Polymermaterial oder eine Keramik. Insbesondere ist Material B so ausgewählt, dass es nicht von geschmolzener Lotlegierung, wie sie für Material A zum Einsatz kommt, benetzt wird. Das Polymermaterial kann ein Homopolymer oder ein Copolymer sein. Das Polymermaterial kann duroplastische oder thermoplastische Eigenschaften aufweisen. Unter duroplastischen Materialien werden allgemein solche verstanden, die sich bei Erwärmung nicht verformen lassen. Besonders bevorzugt ist das Polymermaterial ein duroplastisches Material. Duroplasten werden bevorzugt durch chemisches Vernetzen von Harzen, insbesondere Kunstharzen und Naturharzen hergestellt. Bevorzugt sind die Kunstharze ausgewählt aus Epoxid-Harzen, Polyester-Harzen und Acrylat-Harzen. Das Harz kann ein Ein-oder Mehr-Komponenten-System sein. Das Aushärten bzw. Vernetzten des Harzes wird bevorzugt durch UV-Licht, Wärme oder durch Zugabe einer weiteren Komponente initiiert. Die weitere Komponente kann z.B. ein Vernetzer, ein Katalysator oder ein Initiator sein. Besonders bevorzugt ist das Polymermaterial ein vernetzter Lack, wie z.B. ein Lotstopplack. Ein Lotstopplack verhindert in den Bereichen, in denen er aufgetragen ist, das Benetzen mit geschmolzenem Lot. Der Lotstopplack kann bevorzugt ein ausgehärtetes (vernetztes) Epoxid-Harz enthalten. Ganz besonders bevorzugt ist das Polymermaterial, das als Material B eingesetzt wird, UV-gehärtet, d.h. das verwendete Harz vernetzt unter Einwirkung von UV-Licht (Wellenlänge ca. 200 - 400 nm) aus.

In einer bevorzugten Ausführungsform weist das Material B ein Elastizitätsmodul von 7 GPa oder weniger, insbesondere 5 GPa oder weniger und besonders bevorzugt 2 GPa oder weniger auf. Bevorzugt ist das Material B so ausgewählt, dass es mechanische Spannungen der Kontaktstellen aus Material A kompensieren kann. Der Anteil der Beschichtung mit Material B an der gesamten Oberfläche der Leiterstruktur beträgt zwischen 5% und 95%, bevorzugt zwischen 30% und 80%.

In einer bevorzugten Ausführungsform umfasst das Polymermaterial Füllstoffe. Die Füllstoffe können organische oder anorganische Füllstoffe sein. Insbesondere kann der Füllstoff in Form von Partikeln vorliegen. Der anorganische Füllstoff kann beispielsweise ein Metalloxid sein, das aus der Gruppe bestehend aus TiO₂, ZnO, SiO₂, ZrO₂, SnO₂, CaO und Al₂O₃ ausgewählt ist. Bevorzugt weist der Füllstoff lichtstreuende Eigenschaften auf. Bevorzugt liegt der Füllstoffe als in dem Polymermaterial verteilte Partikel vor. Da Material B ein dielektrisches Material ist, wirkt es als Isolator. Dabei bezieht sich die Isolatorwirkung auf die Schicht aus Material B als Ganzes. Es ist erfindungsgemäß nicht ausgeschlossen, dass das Material B, in Form eines Polymermaterials, als Füllstoff metallische Partikel umfasst. Bevorzugt wird der Füllgrad der metallischen Partikeln im Polymermaterial so gering gehalten, dass die Schicht des Polymermaterials als Ganzes keine erhöhte elektrische Leitfähigkeit gegenüber einem ungefüllten Polymer aufweist. Bevorzugt streuen die metallischen Partikel das sichtbare Licht, insbesondere das auf den Verbinder einfallende Sonnenlicht.

Wenn das Material B, insbesondere das Polymermaterial, einen lichtstreuende Füllstoff enthält, kann Sonnenlicht, das auf den Verbinder einfällt, so gestreut werden, dass es die Solarzelle bzw. das daraus gefertigte Photovoltaikmodul nicht wieder verlässt, sondern durch interne Reflektion in die aktive Halbleiterschicht gelangt und dort zusätzliche Ladungsträger generiert. Dadurch kann der Wirkungsgrad der Solarzelle erhöht werden.

Die Schichtdicke der Schicht aus Material B liegt bevorzugt im Bereich von 5 µm - 40 µm, insbesondere im Bereich von 10 µm - 20 µm. Besonders bevorzugt entspricht die Schichtdicke der Schicht aus Material B der Schichtdicke von Material A.

Die um die Leiterstruktur umlaufenden Bereiche aus Material A und B weisen in einer bevorzugten Ausführungsform jeweils eine Breite im Bereich von 1 - 10 mm auf. Die Breite aller abwechselnd umlaufenden Bereiche aus Material A kann gleich oder verschieden sein. Die Breite aller abwechselnd umlaufenden Bereiche aus Material B kann gleich oder verschieden sein.

Der Anteil des Materials B an der gesamten Oberfläche der Leiterstruktur beträgt vorzugsweise zwischen 5% und 95%, insbesondere zwischen 30% und 80%. In einer besonders bevorzugten Ausführungsform ist die Leiterstruktur in dem Bereichen, in dem der Verbinder nicht mit den zu verbindenden Solarzellenelektroden in Kontakt steht, also zwischen zwei Solarzellen in einem Photovoltaikmodul, vollständig mit einer Schicht aus Material B umgeben. Dadurch kann Lotmaterial eingespart werden, ohne dass dadurch die Alterrungsbeständigkeit reduziert wird.

Bevorzugt umfasst der Verbinder mindestens vier abwechselnd umlaufende Bereiche von Material A. Dabei ist es vorteilhaft, wenn die umlaufenden Bereiche von Material A auf der Leiterstruktur so angeordnet sind, dass jeweils mindestens zwei voneinander getrennte und umlaufende Bereiche von Material A eine erste Solarzellenelektrode kontaktieren können, während mindestens zwei voneinander getrennte und Umlaufende Bereiche von Material A ein weiteres Element kontaktieren können.

Weiterhin betrifft die Erfindung ein Verfahren zur Herstellung eines Verbinders, geeignet zum Verbinden einer ersten Solarzellenelektrode mit einem weiteren Element, umfassend die Schritte:
a) Bereitstellen einer metallischen Leiterstruktur,
b) Teilweises Beschichten einer metallischen Leiterstruktur in mehreren voneinander getrennten und umlaufenden Bereich entlang der Hauptachse, mit einem dielektrische Material B, und
c) Teilweises Beschichten einer metallischen Leiterstruktur in mehreren voneinander getrennten und umlaufenden Bereich entlang der Hauptachse, mit einem Lotmaterial A,
wobei das teilweise Beschichten der Materialien A und B jeweils so erfolgt, dass die Leiterstruktur abwechselnd umlaufend mit diesen Materialien beschichtet wird.

In dem erfindungsgemäßen Verfahren erfolgt Schritt a) notwendiger Weise vor den Schritten b) und c). Die Reihenfolge der Schritte b) und c) ist nicht festgelegt, was auch durch den Begriff "umfassend" zum Ausdruck kommt.

Das erfindungsgemäße Verfahren schließt nicht aus, dass vor, zwischen oder nach den Schritten a) - c) weitere Schritte durchgeführt werden.

In einer bevorzugten Ausführungsform wird die bereitgestellte Leiterstruktur in Schritt a) gereinigt und dadurch von Rückständen, z.B. Fetten und Oxiden befreit.

In Schritt a) wird eine metallische Leiterstruktur bereitgestellt, wie sie im vorherigen Abschnitt beschrieben ist. Bevorzugt wird die Leiterstruktur als fortlaufendes Band oder als fortlaufender Draht auf einer Rolle bereitgestellt, Die aufgerollte Leiterstruktur kann bevorzugt einige zehn bis einige hundert Meter lang sein. Wenn die Leiterstruktur in Form einer Rolle bereitgestellt wird, wird die Leiterstruktur in Schritt a) bevorzugt von der Rolle abgerollt. In einer besonders bevorzugten Ausführungsform erfolgt in Schritt a) zusätzlich eine Vorbehandlung. Die Vorbehandlung kann beispielsweise ausgewählt sein aus Weichglühen und Plasmaätzen in inerter Atmosphäre. Eine inerte Atmosphäre kann zum Beispiel eine Stickstoff- oder Argonatmosphäre sein. Wenn die Leiterstruktur mittels Weichglühen und Plasmaätzen behandelt wird, erfolgt bevorzugt das gesamte Herstellungsverfahren des Verbinders in einer Inertgasatmosphäre.

In Schritt b) wird die metallische Leiterstruktur teilweise in mehreren abwechselnden und umlaufenden Bereich entlang der Hauptachse, mit dielektrischem Material B beschichtet.

Bevorzugt besteht das Beschichten aus zwei Unterschritten. Im ersten Unterschritt wird Material B oder ein Vorläufer von Material B auf die Leiterstruktur aufgebracht und im zweiten Unterschritt wird Material B oder ein Vorläufer von Material B auf der Leiterstruktur fixiert. Wenn das Material B eine Keramik ist, wird bevorzugt ein Vorläufer von Material B in Form einer keramikhaltigen Paste enthaltend Keramikpartikel aufgetragen. Wenn Material B ein Polymermaterial ist, wird bevorzugt ein vernetzbares Harz (insbesondere ein Kunstharz) oder ein Lack auf die Leiterstruktur aufgetragen. Ein vernetzbares Harz und ein Lack können Vorläufer von Material B sein, die in einem weiteren Unterschritt fixiert werden können. Der Lack kann ein Lotstopplack sein, der die Benetzung der Oberfläche der Leiterstruktur mit flüssiger Lotlegierung in den aufgetragenen Bereichen verhindert.

Bevorzugt erfolgt das Auftragen des dielektrischen Materials B durch Drucken. Das Drucken kann als Kontaktdruckverfahren oder als kontaktloses Druckverfahren ausgeführt sein. Das Kontaktdruckverfahren kann ausgewählt sein aus der Gruppe bestehend aus Hochdruck, Flachdruck (z.B. Offsetdruck) und Tiefdruck. In einer Ausführungsform kann jedes der vorgenannten Druckverfahren als Rotationsdruckverfahren durchgeführt werden. Bevorzugt wird das Material B kontinuierlich, z.B. in einem Rolle-zu-Rolle Verfahren, auf die Leiterstruktur aufgebracht. Dazu ist es vorteilhaft, wenn die Leiterstruktur (z.B. ein Metallband) dem Druckprozess kontinuierlich zugeführt wird.

In einer anderen bevorzugten Ausführungsform kann das Material B oder der Vorläufer für Material B durch ein kontaktloses Druckverfahren auf die Leiterstruktur aufgetragen werden. Das kontaktlose Druckverfahren, kann z.B. ausgewählt sein aus Sprühen, Inkjet-Printing oder Tropfen.

Unabhängig vom konkret verwendeten Auftragungsverfahren für Material B ist darauf zu achten, dass das Beschichten umlaufendend erfolgt.

In einer bevorzugten Ausführungsform weist die Leiterstruktur beim Beschichten mit Material B eine Temperatur im Bereich von 40 - 70°C auf, bevorzugt ca. 60±5°C.

Bevorzugt erfolgt das Drucken mit einer Auftragungsgeschwindigkeit im Bereich von 100 m/min, oder bevorzugt bis 300 m/min, wobei sich die Meterangabe auf die Länge der bedruckten Leiterstruktur bezieht.

In einer anderen bevorzugten Ausführungsform kann Material B als Folie auf die Leiterstruktur aufgetragen werden, die auf die Leiterstruktur laminiert wird. Die Folie kann beispielsweise eine Polymerfolie sein.

In einem zweiten Unterschritt erfolgt optional eine Fixierung der Schicht des Materials B, beziehungsweise des Vorläufers für Material B. Durch die Fixierung kann das im ersten Unterschritt aufgetragene Material B chemisch verändert werden, zum Beispiel durch die Vernetzungsreaktion eines Polymernetzwerks. Wenn eine Keramikpaste auf die Leiterstruktur aufgebracht wurde, kann die Fixierung bevorzugt durch einbrennen erfolgen. Bevorzugt führt das Fixieren einer Keramikpaste nicht zu einer Änderung der Zusammensetzung der Keramik.

Die Fixierung eines im ersten Unterschritt aufgetragenen Polymermaterials in Form eines Harzes oder Lacks kann bevorzugt erfolgen durch UV-Strahlung (z.B. mittels Breitband-UV Strahler) oder Wärmezufuhr. Bevorzugt erfolgt während der Fixierung des Harzes eine Vernetzungsreaktion.

Für den Fall, dass eine Folie auf die Leiterstruktur aufgetragen wird, wird diese bevorzugt fixiert. Insbesondere wird die Folie zumindest teilweise auf die Schmelztemperatur erhitzt. Bevorzugt wird durch das Erhitzen die Haftung der Folie zur Leiterstruktur erhöht. In einer alternativen bevorzugten Ausführungsform wird die Folie nicht in einem weiteren Unterschritt behandelt.

Durch die Fixierung der im ersten Unterschritt aufgebrachten Beschichtung auf der Leiterstruktur kann im zweiten Unterschritt unter anderem die Haftung der Schicht zur Leiterstruktur erhöht werden und die Schicht kann selbst Widerstandsfähiger gegen mechanische und chemische Einflüsse gemacht werden.

In einer weiteren bevorzugten Ausführungsform von Schritt b) wird zuerst die Leiterstruktur vollständig mit Material B beschichtet, und anschließend wird die Beschichtung mit Material B teilweise wieder entfernt, sodass voneinander getrennte umlaufende Bereich von Material B auf der Leiterstruktur verbleiben. Das teilweise Entfernen kann beispielsweise mittels Laserablation erfolgen. In einer besonders bevorzugten Ausführung wird die Leiterstruktur zuerst vollständig mit einem Vorläufer von Material B, insbesondere einem Lotstopplack, beschichtet und dieser fixiert, insbesondere vernetzt, und anschließend wird das fixierte Material B teilweise mit Laserablation entfernt. Durch diese Laserablation wird die Oberfläche der Leiterstruktur teilweise wieder freigelegt.

In einer bevorzugten Ausführungsform weist das Material B nach der Fixierung ein Elastizitätsmodul von 7 GPa oder weniger, insbesondere 5 GPa oder weniger und besonders bevorzugt 2 GPa oder weniger auf. Bevorzugt ist das Material B so ausgewählt, dass es mechanische Spannungen der Kontaktstellen aus Material A kompensieren kann. Der Anteil der Beschichtung mit Material B an der gesamten Oberfläche der Leiterstruktur beträgt zwischen 5% und 95%, bevorzugt zwischen 30% und 80%.

In einer besonders bevorzugten Ausführungsform erfolgt vor Schritt c) eine Vorbehandlung. Die Vorbehandlung kann beispielsweise das Aufbringen eines Flussmittels auf die nicht mit Material B beschichteten Bereiche der Leiterstruktur enthalten. Das Auftragen kann insbesondere notwendig sein, wenn das Herstellungsverfahren nicht vollständig unter eine Inertgasatmosphäre durchgeführt wird.

In Schritt c) erfolgt ein teilweises Beschichten der metallischen Leiterstruktur in mehreren voneinander getrennten und umlaufenden Bereichen entlang der Hauptachse, mit einem Lotmaterial A. Bevorzugt erfolgt die Beschichtung der Leiterstruktur mit Material A nur in den Bereichen, die nicht mit Material B beschichtet sind. Wenn es sich um ein Kupferband handelt, wird zum Beispiel bevorzugt nur die freie Kupferoberfläche mit Lotmaterial bedeckt. Die Beschichtung mit Material B, die bevorzugt ein Polymermaterial und insbesondere ein gehärteter Lotstopplack ist, wird von flüssiger, geschmolzener Lotlegierung nicht benetzt.

Das Beschichten der Leiterstruktur mit Lotmaterial kann auf unterschiedliche Weise erfolgen. In einer bevorzugten Ausführungsform kann die bereits mit Material B beschichtete Leiterstruktur durch eine Tauchbeschichtung mit Material A beschichtet werden. Bei der Tauchbeschichtung kann die bereits mit Material B beschichtete Leiterstruktur in ein Schmelzbad aus flüssiger Lotlegierung oder eine Bad einer Lotpaste getaucht werden. Eine Tauchbeschichtung hat den Vorteil, dass besonders einfach voneinander getrennte, umlaufende Schichten aus Material A auf der mit Material B vorbeschichteten Leiterstruktur hergestellt werden können. Durch die Tauchbeschichtung können die nicht mit Material B beschichteten Bereiche der Leiterstruktur umlaufend mit Material A beschichtet werden. Bevorzugt wird die Leiterstruktur in ein Bad aus flüssiger Lotlegierung eingetaucht. Bevorzugt wird die Leiterstruktur, insbesondere ein Kupferband, kontinuierlich durch ein Schmelzbad einer Lotlegierung geführt. Die Lotlegierung des Schmelzbads weist bevorzugt einen Schmelzpunkt auf, der mindestens 100°C, insbesondere mindestens 200°C, unter der Schmelztemperatur der Leiterstruktur liegt. Die Lotlegierung kann ausgewählt sein aus den Lotlegierungen wie sie hierin beschrieben sind.

Anschließend kann überschüssige, flüssige Lotlegierung, z.B. mit Druckluft oder durch Abstreifen, entfernt werden. Bevorzugt weist die Schicht von flüssiger Lotlegierung auf der Leiterstruktur die gleiche oder zumindest eine ähnliche Schichtdicke auf wie die Schicht aus Material A.

Nach dem Durchlaufen des Schmelzbads kann die flüssige Lotlegierung abkühlen und erstarren, wodurch abwechselnde und umlaufende Bereiche des Lotmaterials A und des dielektrischen Materials B auf der Leiterstruktur gebildet werden können.

In einer alternativen Ausführung der Erfindung kann die bereits mit Material B beschichtete Leiterstruktur durch Bedrucken der Leiterstruktur mit einer Lotpaste beschichtet werden.

Bevorzugt enthält die Lotpaste mindestens Partikel einer Lotlegierung und ein Flussmittel. Weiterhin kann die Lotpaste Lösungsmittel und Additive umfassen. Die Lösungsmittel können organische oder wässrige Lösungsmittel sein. Die Additive können bevorzugt Rheologiemodifizierer, wie z.B. Thixotropiemittel, Verdicker oder Harze, sein. Das Lösungsmittel kann ein organisches Lösungsmittel oder ein wässriges Lösungsmittel sein.

In einem ersten Schritt wird die Lotpaste auf die Bereiche der Leiterstruktur aufgedruckt, die nicht mit Material B beschichtet sind. In einem weiteren Schritt nach dem Beschichten kann die Lotpaste auf der Leiterstruktur fixiert werden. Das Fixieren der Lotpaste geschieht bevorzugt durch Erwärmen oder Erhitzen. Erwärmen bedeutet in diesem Zusammenhang, dass die Lotpaste unter den Schmelzpunkt der enthaltenen Lotlegierung erwärmt wird, so dass die Schicht der Paste trocknet und flüchtige Bestandteile entweichen. Erhitzen meint in diesem Zusammenhang, dass die Schicht der Lotpaste über den Schmelzpunkt der enthaltenen Lotlegierung erhitzt wird. Bevorzugt wird beim Erhitzen eine zusammenhängende Schicht einer Lotlegierung gebildet, während die flüchtigen Bestandteile der Paste weitestgehend entfernt werden, z.B. durch Verdampfen oder Verbrennen. Auf diese Weise kann ein erfindungsgemäßer Verbinder erzeugt werden.

Wie oben bereits ausgeführt, ist die Reihenfolge der Schritte b) und c) nicht weiter festgelegt. In einer vorteilhaften Ausbildung der Erfindung kann der Verbinder hergestellt werden, in dem zuerst eine Schicht aus Lotmaterial A auf die Leiterstruktur aufgebracht wird und anschließend eine Schicht aus dielektrischem Material B. Diese Verfahrensreihenfolge kann beispielsweise dadurch realisiert werden, dass zuerst ein Lotmaterial A in Form einer Lotpaste in voneinander getrennten und umlaufenden Bereichen entlang der Hauptrichtung auf die Leiterstruktur aufgebracht wird und anschließend eine Schicht des Materials B auf die nicht mit Material A beschichteten Bereiche. Bevorzugt erfolgt in dieser Ausführungsform, bei der Schritt b) nach Schritt c) erfolgt, sowohl das Aufbringen von Material A als auch von Material B jeweils durch einen Druckprozess.

Auf dem erzeugten erfindungsgemäßen Verbinder wechseln die mit Material B versehenen Bereiche mit den mit Material A beschichteten Bereichen ab und sind jeweils zwischen 1 mm und 10 mm lang. Die voneinander getrennten Bereiche beschichten die Leiterstruktur jeweils umlaufend.

Wenn die Leiterstruktur in Schritt a) als fortlaufendes Band oder Draht bereitgestellt wurde, wird die Leiterstruktur nach Ablauf der Schritte b) und c) bevorzugt in einzelne Stücke geschnitten und so der fertige Verbinder erhalten. Bevorzugt wird die mit den Materialien A und B beschichtete Leiterstruktur so zerschnitten, dass der erhaltene Verbinder mindestens vier Bereiche von Material A aufweist, zwischen denen Bereiche von Material B vorliegen. Die Länge der zerschnittenen Leiterstruktur liegt bevorzugt im Bereich von 100 - 600 mm und ganz besonders bevorzugt im Bereich von 200 - 400 m.

Die in den Schritten b) und c) beschichtete Leiterstruktur kann optional, nachdem der Beschichtungsvorgang beendet ist, wieder auf eine Rolle (auch Spule genannt) aufgerollt werden. Besonders bevorzugt wird die Leiterstruktur nach Ablauf der Schritte b) und c) wieder aufgerollt und erst während des Verfahrens zur Herstellung eines Photovoltaikbauteils abgerollt und auf die jeweils für die Anwendung benötigte Länge zugeschnitten.

In einer Ausführungsform betrifft die Erfindung ein Photovoltaikbauteil, umfassend eine erste Solarzellenelektrode und ein weiteres Element, wobei die Solarzellenelektrode und das weitere Element durch einen erfindungsgemäßen Verbinder verbundenen sind. Eine Solarzellenelektrode ist auf einer Solarzelle angeordnet. Bevorzugt ist die erste Solarzellenelektrode des Photovoltaikbauteils eine Frontseiten- oder eine Rückseitenelektrode. Eine Solarzelle enthält bevorzugt mindestens ein Halbleitersubstrat, das von mindestens zwei Solarzellenelektroden entgegengesetzter Polarität kontaktiert wird. Das Halbeitersubstrat ist bevorzugt ein dotierter Siliziumwafer. Bevorzugt ist das Halbleitersubstrat ein monokristalliner oder multikristalliner Siliziumwafer. Typischer Weise sind die mindestens zwei Solarzellenelektroden einer Solarzellen mindestens eine Rückseitenelektrode und mindestens eine Frontseitenelektrode, das heißt, die Elektroden sind auf entgegengesetzten Seiten der Halbleiterschicht angeordnet. Die Frontseitenelektrode befindet sich auf der lichteinfallenden Seite, während sich die Rückseitenelektrode auf der vom Licht abgewandten Seite befindet. In einer anderen Ausführungsform können die mindestens zwei Elektroden auf der gleichen Seite des Halbleitersubstrats angeordnet sein (auch Back Contact Solar Cell genannt).

Die Rückseitenelektrode kann zum Beispiel eine flächig aufgetragene Metallschicht sein. Vorzugsweise enthält diese Metallschicht Aluminium mit silberhaltigen Kontaktierungsstellen.

Die Frontseitenelektrode ist bevorzugt eine Fingerelektrode oder ein Busbar. Unter einer Fingerelektrode ist eine Elektrode zu verstehen, die als einige Mikrometer dünne Linie auf der Solarzelle angeordnet ist und dazu dient möglichst über die gesamte Flächen der Solarzelle Ladungsträger einzusammeln. Typischer Weise überspannt eine Vielzahl von Fingerelektroden die Frontseite einer Halbleiterschicht, insbesondere eines Silizium-Wafers. Bevorzugt lieg der mittlere Durchmesser einer Fingerelektrode im Bereich von 20 - 150 µm.

Bevorzugt ist auf einer Fingerelektrode zusätzlich ein Busbar angeordnet. Der Busbar kann mehrere oder alle Fingerelektroden miteinander verbinden und dient dazu, den von den Fingerelektroden gesammelten Strom effizient abzuleiten. Gleichzeitig kann ein Busbar dazu dienen mechanisch robuste Kontaktflächen, z.B. zum Löten, zur Verfügung zu stellen. Ein Busbar hat bevorzugt einen größeren Leitungsquerschnitt als eine Fingerelektrode. Der Durchmesser eines Busbars kann im Bereich von 100 µm - 2 mm liegen und die Höhe beträgt bevorzugt 1 - 20 µm. Bevorzugt weist ein Busbar eine geringere Haftung zum Halbleitersubstrat auf als die Fingerelektroden, die dieser miteinander verbindet. Für den Busbar sind dem Fachmann unterschiedliche Designs bekannt. Ein Busbar kann als durchgehende gleichförmige Leiterbahn, eingeschnürte Leiterbahn (in Form einer Perlenkette) sowie mit Unterbrechungen ausgeführt sein. In einer bevorzugten Ausführungsform kontaktiert ein Busbar mehrere, insbesondere alle vorhandenen Fingerelektroden. Der Busbar dient bevorzugt als Kontaktfläche, insbesondere als Lötfläche, für einen erfindungsgemäßen Verbinder.

Sowohl die Rückseitenelektrode als auch die Frontseitenelektrode werden bevorzugt hergestellt, indem eine Leiterpaste auf der Halbleiterschicht aufgetragen wird und die aufgetragene Leiterpaste anschließend eingebrannt wird. Die Leiterpaste kann durch Drucken, wie z.B. Siebdrucken oder Schablonendrucken, auf der Halbleiterschicht aufgetragen werden. Eine Leiterpaste umfasst typischer Weise elektrisch leitfähige Metallpartikel, eine Glasfritte und ein organisches Medium. Wenn die Leiterpaste zur Herstellung einer Rückseitenpaste eingesetzt wird, enthalten die elektrisch leitfähigen Metallpartikel bevorzugt Aluminium oder bestehen aus Aluminium. Wenn die Leiterpaste zur Herstellung einer Frontseitenpaste eingesetzt wird, enthalten oder bestehen die elektrisch leitfähigen Metallpartikel bevorzugt aus Silber. Nach dem Auftragen kann das Halbleitersubstrat zusammen mit der bzw. den aufgetragenen Leiterpasten gebrannt werden, wodurch die eine Solarzellelektrode erhalten wird. Durch das Brennen kann das organische Medium entfernt werden und eine mechanisch feste und elektrisch leitfähige Elektrode erhalten werden. Die erhalten Solarzellelektroden umfassen somit bevorzugt eine Mischung aus Glas und Metall.

In dem erfindungsgemäßen Photovoltaikbauteil wird eine erste Solarzellenelektrode über den erfindungsgemäßen Verbinder mit einem weiteren Element verbunden. Bevorzugt ist das weitere Element eine weitere Solarzellenelektrode einer Solarzelle. Besonders bevorzugt ist das weitere Element eine weitere Solarzellenelektrode mit entgegengesetzter Polarität zur ersten Solarzellenelektrode. Zum Beispiel können die erste Solarzelle und die weitere Solarzelle gleich sein. Der Verbinder verbindet bevorzugt die Frontseitenelektrode der ersten Solarzellen mit der Rückseitenelektrode der weiteren Solarzelle. Alternativ kann der Verbinder auch die Rückseitenelektrode einer ersten Solarzelle mit der Frontseitenelektrode einer weiteren Solarzelle verbinden. Das erfindungsgemäße Photovoltaikbauteil kann auch Teil einer Kette von Solarzellen sein, die durch den Verbinder verbunden sind, d.h. neben der ersten und der weiteren Solarzellenelektrode können weitere Solarzellenelektroden jeweils mit weiteren Verbindern verbunden sein.

In einer bevorzugten Ausführung wird der Kontakt zwischen der ersten Solarzellenelektrode und dem Verbinder durch eine Lotverbindung hergestellt. Dabei tragen die abwechselnd umlaufenden Bereiche auf dem Verbinder, die mit einer Schicht aus einem Lotmaterial A beschichtet sind, zum mechanischen und elektrischen Kontakt bei. Besonders vorteilhaft wird der elektrische Kontakt zwischen Verbinder und der Solarzellenelektrode durch mindestens zwei umlaufende Bereiche aus Material A hergestellt. Bevorzugt wird auch der elektrische Kontakt zwischen Verbinder und dem weiteren Element durch mindestens zwei umlaufende Bereiche von Material A hergestellt, wobei die Bereiche von Material A jeweils durch eine Schicht aus Material B voneinander getrennt sind. Demzufolge weist der erfindungsgemäße Verbinder bevorzugt mindestens vier Bereiche aus Material A auf der Leiterstruktur auf. Dadurch, dass der Verbinder die Solarzellenelektrode nicht flächig kontaktiert sondern bereichsweise, kann die Alterungsbeständigkeit, innerhalb eines Solarmoduls, verbessert werden z.B. durch Kompensation mechanischer Spannungen, die aus unterschiedlichen thermischen Ausdehnungen resultieren. Insbesondere ist es bevorzugt, wenn mindestens vier, insbesondere mindestens zehn und ganz besonders bevorzugt mindestens 35 abwechselnd umlaufende Bereiche aus Material A auf dem Verbinder vorliegen.

Im erfindungsgemäßen Photovoltaikbauteil haben die abwechselnd umlaufenden Bereiche aus Material B dielektrische Eigenschaften und tragen bevorzugt nicht zum elektrischen Kontakt zwischen Solarzellenelektrode und Verbinder bei. In einer bevorzugten Ausführung tragen die abwechselnd umlaufenden Bereiche aus Material B zur mechanischen Kontaktierung bei, z.B. durch Haftung, indem Material B als Klebstoff wirkt.

Das erfindungsgemäße Photovoltaikbauteils wird bevorzugt hergestellt, durch ein Verfahren umfassend die folgenden Schritte:
- Bereitstellen einer Solarzelle mit mindestens einer Solarzellenelektrode und Bereitstellen eines weiteren Elements
- Bereitstellen eines erfindungsgemäßen Verbinders,
- Positionieren des Verbinders relativ zu der mindestens einen Solarzellenelektrode und dem weiteren Element,
- Verbinden der mindestens einen Solarzellenelektrode und des weiteren Elements mit Hilfe des Verbinders

Im folgenden Abschnitt ist die Herstellung eines erfindungsgemäßen Photovoltaikbauteils beschrieben, bei dem eine Solarzellenelektrode durch einen Verbinder mit einem weiteren Element verbunden ist. Die Erfindung umfasst jedoch auch Ausführungsformen, bei denen eine Solarzelle mehrere Solarzellenelektroden aufweist, die jeweils über einen Verbinder mit dem weiteren Element verbunden werden.

Um das Photovoltaikbauteil herzustellen, wird eine Solarzelle bereitgestellt, die mindestens eine Solarzellenelektrode aufweist. Bevorzugt umfasst die Solarzelle mindestens eine Frontseitenelektrode, z.B. in Form eines Busbars, und eine Rückseitenelektrode. Das weitere Element ist bevorzugt eine weitere Solarzellenelektrode einer Solarzelle. Insbesondere ist die weitere Solarzelle gleich mit der ersten bereitgestellten Solarzelle. Alternativ kann das weitere Element des Photovoltaikmoduls auch eine Anschlussleitung für ein Photovoltaikmodul sein. Die Anschlussleitung kann dazu dienen den Strom von mehreren in Reihe geschalteten Solarzellen abzuleiten.

Weiterhin wird mindestens ein erfindungsgemäßer Verbinder bereitgestellt. Bevorzugt wird der Verbinder bereitgestellt, indem eine abwechselnd und umlaufend mit den Materialien A und B beschichtete Leiterstruktur von einer Rolle abgerollt wird. Bevorzugt wird diese abgerollte Leiterstruktur auf die erforderliche Länge zugeschnitten und dadurch ein für die jeweilige Anwendung passender Verbinder erhalten. Insbesondere wird der Verbinder derart bereitgestellt, dass die Länge ausreicht, um den Busbar einer Solarzelle mit der Solarzellenelektrode einer weiteren Solarzelle, insbesondere einer Rückseitenelektrode, zu verbinden. Das bedeutet, dass der Verbinder etwa doppelt so lang ist wie die Länge einer Solarzelle. In einer bevorzugten Ausführungsform entspricht die Zahl der bereitgestellten Verbinder der Zahl der Busbars, die auf der Solarzelle vorhanden sind. Insbesondere wird pro vorhandenem Busbar eine Rolle mit beschichteter Leiterstruktur bereitgestellt, die zu dem erfindungsgemäßen Verbinder zugeschnitten werden kann.

Weiterhin wird der bereitgestellte Verbinder relativ zu der Solarzellenelektrode und dem weiteren Element positioniert. Dazu wird bevorzugt der bereitgestellte Verbinder mit der ersten Solarzellenelektroden, insbesondere dem Busbar, in Deckung gebracht, z.B. über dem Busbar zentriert. Da der Verbinder bevorzugt länger ist als der Busbar, steht ein Teil, z.B. die Hälfte der Länge, des Verbinders über die erste Solarzelle über.

Anschließend wird das weitere Element so positioniert, das es mit dem Verbinder kontaktiert werde kann. Wenn eine Frontseitenelektrode einer ersten Solarzelle mit einer Rückseitenelektrode einer weiteren Solarzelle verbunden werde soll, kann der Verbinder zuerst auf der Frontseite entsprechend positioniert werden und anschließend kann die weitere Solarzelle mit ihrer Rückseite auf dem überstehenden Teil des Verbinder positioniert werden.

Der auf der Solarzellenelektrode und dem weiteren Element positionierte Verbinder wird anschließend mit diesen Verbunden.

Das Verbinden erfolgt bevorzugt, indem der positionierte Verbinder angepresst und verlötet wird. Zum Verlöten wird bevorzugt die Anordnung aus Solarzellenelektrode, Verbinder und weiterem Element so erhitzt, dass die abwechselnd umlaufenden Bereiche des Lotmaterials A auf dem Verbinder schmelzen und eine Lötverbindung hergestellt wird. Das Erhitzen des Lotmaterials erfolgt vorzugsweise mit Hilfe von Infrarotstrahlung.

Es kann bevorzugt sein, die Solarzellenelektrode und das weitere Element vor dem eigentlichen Löten vorzuheizen, um die mechanischen Spannungen zu minimieren. Weiterhin werden der Zellverbinder und die Solarzellenelektrode vorzugsweise während des Lötprozesses zusammengepresst. Nach dem Löten wird in den Bereichen des Verbinders, die abwechselnd und umlaufend mit Lotmaterial A beschichtet sind eine mechanisch feste und elektrisch leitfähige Verbindung erhalten. Ein Photovoltaikbauteil, bei dem die erste Solarzellenelektrode über einen Verbinder mit einer weiteren Solarzellenelektrode einer weiteren Solarzelle verbunden ist, wird auch Photovoltaikmodul genannt. Der erfindungsgemäße Verbinder kann bevorzugt auch dazu verwendet werden, mehr als zwei Solarzellen zu Photovoltaikmodulen zu verbinden.

Der erfindungsgemäße Verbinder lässt sich in einem industrieüblichen Prozess analog zu vollständig mit Lot beschichteten Kupferbändern verarbeiten und ermöglichen somit die elektrische Reihenschaltung und mechanische Verbindung von Solarzellen für die Fertigung von Solarmodulen mit verbesserter Alterungsstabilität.

Im Folgenden soll die allgemeine Lehre der Erfindung anhand von konkreten Ausführungsbeispielen erläutert werden.

### Beispiele

### 1) Herstellung eines abwechselnd umlaufend beschichteten Verbinders

Zuerst wurde eine metallische Leiterstruktur in Form eines auf eine Spule aufgerollten Kupferbandes bereitgestellt (Kupfer: ETP-Standard, Rp0,2 = 80 MPa, Maße: 1,5 mm breit, 200 µm dick). Das Kupferband wurde von der Spule abgerollt. Anschließend wurde UV härtender Lotstopplack (ELPEPCB® SD 2460/201 UV-FLEX) im Tiefdruckverfahren auf das abgerollte Kupferband aufgebracht. Die Streifen des aufgedruckten Lotstopplacks wiesen eine Breite von 3 mm auf und waren jeweils 3 mm voneinander entfernt. Der aufgebrachte Lotstopplack wurde darauffolgend mittels UV-Licht einer Quecksilber-Hochdruckdampflampe bei einer Oberflächentemperatur des Substrats von ca. 60 °C gehärtet. Die Schichtdicke der Lackschicht nach dem Härten betrug 15 µm. Im nächsten Schritt wurde das teilweise mit Lotstopplack beschichtete Kupferband in ein Lotbad getaucht, das geschmolzene Lotlegierung (Sn60Pb40) enthielt. Nach dem Herausziehen des Kupferbands war das Kupferband in den 3 mm breiten Bereichen mit Lotlegierung benetzt, die nicht mit Lotstopplack beschichtet waren. Die Bereiche des Lotstopplacks waren nicht mit Lotlegierung benetzt. Nach dem Erstarren wies die Schicht der Lotlegierung eine Schichtdicke von etwa 15 µm auf. Nach dem Erstarren wurde das beschichtete Kupferband wieder auf eine Spule aufgerollt.

Analog zum ersten Verbinder wurden weitere Verbinder hergestellt, bei dem der Lotstopplack zusätzlich 5 Gew.% TiO₂-Pulver enthielt.

### 2) Bereitstellung von Solarzellen

Als Solarzelle wurde eine p-Typ Zelle mit n-Emitter der Fa. Q-Cells eingesetzt (Widerstand: 90 Ohm/square). Die Oberfläche wies eine Si₃Nₓ Antireflektiv-Beschichtung auf der Vorderseite auf. Mit der kommerziell erhältlichen Paste Heraeus SOL 9631C (Heraeus Deutschland GmbH) wurden Finger und drei Busbars auf der Vorderseite mittels Siebdruck aufgetragen. Die Linienbreite der Finger betrug 40 µm. Siebgedruckte Silber-Lötpads wurden auf der Rückseite mit der kommerziellen Paste Heraeus SOL205B (Heraeus Deutschland GmbH) aufgebracht. Die Aluminium - BSF auf der Rückseite wurde mittels siebgedruckter kommerzieller Aluminium-Paste ((RUX28K30, Guangzhou Ruxing Technology Development Co., Ltd. of Guangdong, China) aufgedruckt. Die Pasten wurden getrocknet und mit einer Maximaltemperatur von 900°C eingebrannt.

### 3) Herstellung von Photovoltaikmodulen:

Aus den zwei unterschiedlichen Arten von abwechselnd umlaufenden Verbindern (einmal mit und einmal ohne TiO₂ im Lötstopplack) wurden, mit Hilfe des nachfolgend beschriebenen Verfahrens, Photovoltaikmodule aus zwei Solarzellen hergestellt:

Eine erste Solarzelle, so wie sie in Beispiel 2 hergestellt wurden, wurde auf einer Montagefläche so positioniert, dass die Frontseitenelektroden mit den Busbars jeweils oben lagen.

Abwechselnd umlaufend mit Lötstopplack und Lot beschichtetes Kupferband wurde auf Spulen aufgerollt bereitgestellt. Für jeden der drei Busbars pro Solarzelle wurde eine eigene Spule mit abwechselnd umlaufend beschichtetem Metallband bereitgestellt.

Die abwechselnd umlaufend beschichteten Metallbänder wurden abgerollt, gereckt und über Führungen zu den Busbars der ersten Solarzelle geführt. Über den drei Busbars wurden die beschichteten Kupferbänder jeweils so positioniert und ausgerichtet, dass möglichst wenig Fläche der Solarzellen-Frontseite abgedunkelt wurde.

Die Verbinder wurden nach dem Abrollen und Positionieren über der ersten Solarzelle so zugeschnitten, dass die Länge der Verbinder für die Abdeckung von zwei benachbarten Solarzellen ausreicht. Das bedeutet, dass die Länge eines zugeschnittenen Verbinders etwa doppelt so lang war wie die Länge der ersten Solarzelle. Eine Hälfte der jeweils abgerollten Kupferbänder kontaktierte einen Busbar auf der Frontseite der ersten Solarzelle, während die andere Hälfte der Verbinder über die Solarzelle hinaus ragte. Auf die Teile der drei Verbinder, die über die erste Solarzelle hinaus ragten, wurde die zweite Solarzelle gelegt. Dabei wurde die zweite Solarzelle so positioniert, dass die Verbinder die Rückseite der zweiten Solarzelle kontaktieren.

Nach dem Positionieren der zweiten Solarzelle wurden die Solarzellen und der Verbinder zusammengepresst. Anschließend wurde die Anordnung aus den zwei Solarzellen und dem Verbinder mittels IR-Strahlung so erhitzt, dass das Lotmaterial auf dem Verbinder eine Temperatur von etwa 200°C erreichte. Nach dem Erhitzen wurde die Anordnung abgekühlt, wobei die geschmolzene Lotlegierung erstarrte. Dadurch wurde ein betriebsbereites Photovoltaikmodul bestehend aus zwei Solarzellen erhalten.

Zum Vergleich wurde ein weiteres Photovoltaikmodul aus zwei Solarzellen hergestellt, bei dem die Verbindung der zwei Solarzellenelektroden mit einem herkömmlichen, vollständig mit Lotlegierung (Sn60Pb40) beschichteten Kupferband erfolgte.

Die drei hergestellten Photovoltaikmodule wurde zyklischen Temperaturwechseln zwischen -40 bis +55°C ausgesetzt. Die Modulleistung der Photovoltaikmodule wurde nach 100, 300, 500 und 1000 Temperaturzyklen gemäß den in der Norm (IEC 61215) vorgegebenen Parametern getestet. Die Leistung STC der Module wurde bei 1000 W/m² und einen Zelltemperatur von 25°C nach IEC 60904 erfasst.

Ergebnis der Modulleistung nach thermischer Wechselbelastung für Module, die mit unterschiedlichen Zellverbindern verschaltet sind:
A. Standard Zellverbinder (lotbeschichtetes Kupferband)
B. Selektiv beschichteter Zellverbinder ohne Füllstoff im Lack
C. Selektiv beschichteter Zellverbinder mit Füllstoff im Lack

Tabelle 1 zeigt die Ergebnisse der Messungen für die Modulleistung, bezogen auf den Standard Zellverbinder (A) nach entsprechender Zyklenzahl bei TCT Test gem. Norm (s.o.):

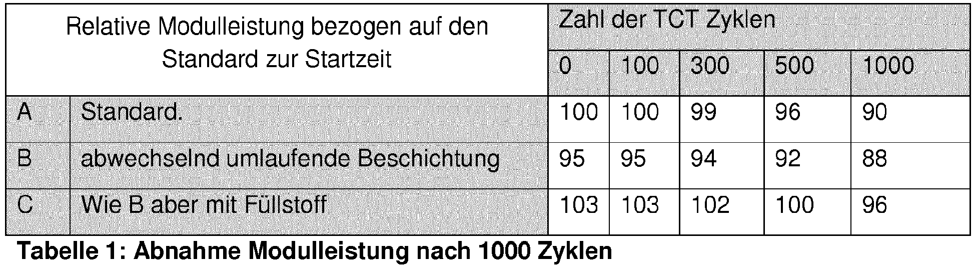

Die prozentuale Abnahme der Modulleistung nach 1000 Temperaturzyklen betrug: A 10,0%, B 7,4% und C 6,8%. Der Vergleich zwischen A und B zeigt, dass die Modulleistung bei der Verwendung von abwechselnd umlaufend beschichteten Verbindern über die Dauer von 1000 Temperaturwechselzyklen weniger abnimmt als bei vollständig mit Lot beschichteten Verbindern.

## Patentansprüche

1. Verbinder zum Verbinden einer ersten Solarzellenelektrode mit einem weiteren Element, wobei der Verbinder eine metallische Leiterstruktur aufweist, **dadurch gekennzeichnet, dass** die Leiterstruktur entlang der Hauptrichtung abwechselnd umlaufend mit den Materialien A und B beschichtet ist, wobei A ein Lotmaterial und B ein dielektrisches Material ist.

2. Verbinder gemäß Anspruch 1, **dadurch gekennzeichnet, dass** die Leiterstruktur mindestens vier voneinander getrennte Bereiche aufweist, die mit Lotmaterial A beschichtet sind.

3. Verbinder gemäß einem der Ansprüche 1 oder 2, **dadurch gekennzeichnet, dass** die Leiterstruktur ein Band oder ein Draht ist.

4. Verbinder gemäß einem der Ansprüche 1 - 3, **dadurch gekennzeichnet, dass** die Leiterstruktur Kupfer enthält oder aus Kupfer besteht.

5. Verbinder gemäß einem der Ansprüche 1 - 4, **dadurch gekennzeichnet, dass** das dielektrische Material B Füllstoff aufweist, der ausgewählt ist aus der Gruppe bestehend aus dielektrischen Materialien und metallischen Materialien.

6. Verbinder gemäß einem der Ansprüche 1 - 5, **dadurch gekennzeichnet, dass** der Füllstoff ein Metalloxidpulver ist.

7. Verbinder gemäß einem der Ansprüche 1 - 6, **dadurch gekennzeichnet, dass** das Material B ein Polymermaterial ist.

8. Verbinder gemäß einem der Ansprüche 1 - 7, **dadurch gekennzeichnet, dass** das Material B ein Elastizitätsmodul von 7 GPa oder weniger aufweist.

9. Verfahren zur Herstellung eines Verbinders gemäß einem der Ansprüche 1 - 8, geeignet zum Verbinden einer ersten Solarzellenelektrode mit einem weiteren Element, umfassend die Schritte:
a) Bereitstellen einer metallischen Leiterstruktur,
b) teilweises Beschichten einer metallischen Leiterstruktur in mehreren voneinander getrennten und umlaufenden Bereich entlang der Hauptachse, mit einem dielektrische Material B, und
c) teilweises Beschichten einer metallischen Leiterstruktur in mehreren voneinander getrennten und umlaufenden Bereich entlang der Hauptachse, mit einem Lotmaterial A,
wobei das teilweise Beschichten der Materialien A und B jeweils so erfolgt, dass die Leiterstruktur abwechselnd umlaufend mit diesen Materialien beschichtet wird.

10. Verfahren gemäß Anspruch 9, wobei die Leiterstruktur zuerst mit Material B beschichtet wird.

11. Verfahren gemäß einem der Ansprüche 9 oder 10, wobei, das teilweise Beschichten mit Material B durch Drucken erfolgt.

12. Verfahren gemäß einem der Ansprüche 9-11, **dadurch gekennzeichnet, dass** Schritt c) durch Eintauchen der Leiterstruktur in eine flüssige Lotlegierung erfolgt.

13. Photovoltaikbauteil umfassend eine erste Solarzellenelektrode und ein weiteres Element, wobei die Solarzellenelektrode und das weitere Element durch einen Verbinder gemäß einem der Ansprüche 1 - 8 miteinander verbundenen sind.

14. Photovoltaikbauteil gemäß Anspruch 13, wobei das weitere Element eine weitere Solarzellenelektrode ist.

15. Photovoltaikbauteil gemäß Anspruch 13 oder 14, wobei die erste Solarzellenelektrode eine Frontseitenelektrode ist und das weitere Element eine Rückseitenelektrode ist.
